# EUROPEAN PATENT APPLICATION

(11) **EP 4 641 221 A1**
(43) Date of publication of application: **29.10.2025**
(21) Application number: 23906068.4
(22) Date of filing: 21.12.2023
(51) Int. Cl.: G01R 15/24, G01R 33/00, G01R 33/032

(54) **OPTICAL FIBER SENSOR AND MAGNETIC FIELD STRENGTH MEASURING APPARATUS**

(30) Priority: 21.12.2022 CN 202211651105
(71) Applicant: The Hong Kong Polytechnic University, Hung Hom, Kowloon Hong Kong (CN)
(72) Inventor: LAI, Chun Cheung, Hong Kong (CN); WANG, Sumei, Hong Kong (CN); NI, Yiqing, Hong Kong (CN)
(74) Representative: MERH-IP Matias Erny Reichl Hoffmann Patentanwälte PartG mbB
(86) International application number: PCT/CN2023/140767
(87) International publication number: WO 2024/131913

(57) **Abstract**

The present application relates to the technical field of optical fiber sensing, and provides an optical fiber sensor and a magnetic field intensity measurement device. The optical fiber sensor includes: at least one optical fiber and a magnetic component; the at least one optical fiber is extended and arranged along a preset direction, a preset position is arranged on an extension length of the optical fiber, and a Bragg grating is formed at the preset position; and the magnetic component is connected to the preset position of the optical fiber, the magnetic component is capable of positional offset under an action of a magnetic force to cause the Bragg grating at the preset position to undergo bending and deformation perpendicular to the preset direction. The magnetic field intensity measurement device includes the above optical fiber sensor. The present application aims to solve the technical problem in the existing technology that the current-carrying conductors are prone to electromagnetic and radio frequency interference, resulting in inaccurate measurement of magnetic field intensity.

## Description

The present application claims priority of a Chinese patent application, with application No. 202211651105.4, filed on December 21, 2022 to CNIPA, entitled "optical fiber sensor and magnetic field intensity measurement device"; the contents of which are incorporated into the present application by reference.

### TECHNICAL FIELD

The present application relates to the technical field of optical fiber sensing, and more particularly to an optical fiber sensor and a magnetic field intensity measurement device.

### BACKGROUND

Magnetic field sensors are an important component in the field of sensors. The measurement of magnetic field intensity has been widely applied in aerospace, information storage, environmental monitoring and other fields.

Most traditional methods for measuring and quantifying magnetic field intensity are based on the Ampere force theory. The Ampere force refers to the force acting on a current-carrying conductor in a magnetic field. In traditional magnetic field sensors for measuring and quantifying magnetic field intensity, current-carrying conductors are used as sensing elements.

However, traditional magnetic field sensors using current-carrying conductors are prone to electromagnetic interference (EMI) or radio frequency interference (RFI) during the measurement process, thereby affecting the accuracy of the measurement.

### TECHNICAL PROBLEM

Objectives of the present application are to provide an optical fiber sensor and a magnetic field intensity measurement device, which aims to solve the technical problem in the existing technology that the current-carrying conductors are prone to electromagnetic and radio frequency interference, resulting in inaccurate measurement of magnetic field intensity.

### SUMMARY

A first objective of the present application is to provide an optical fiber sensor, which includes: at least one optical fiber and a magnetic component;
the at least one optical fiber is extended and arranged along a preset direction, a preset position is arranged on an extension length of the optical fiber, and a Bragg grating is formed at the preset position; and
the magnetic component is connected to the preset position of the optical fiber, the magnetic component is capable of positional offset under an action of a magnetic force to cause the Bragg grating at the preset position to undergo bending and deformation perpendicular to the preset direction.

**In** one of embodiments, the optical fiber sensor further includes a support beam capable of bending and deformation, the optical fiber and the magnetic component are both connected to the support beam, and the optical fiber is extended and arranged in a same direction as the support beam.

**In** one of embodiments, the support beam is located on a side of the optical fiber away from the magnetic component; or
the support beam is located on a side of the optical fiber facing the magnetic component and is located between the optical fiber and the magnetic component.

**In** one of embodiments, two optical fibers are provided, the two optical fibers are respectively connected in parallel to opposite sides of the support beam, and the two Bragg gratings on the two optical fibers are respectively arranged correspondingly; and the magnetic component is connected to a side of any of the two optical fibers away from the support beam.

**In** one of embodiments, the optical fiber sensor further includes a spacer plate configured to separate the magnetic component from the optical fiber arranged close to the magnetic component; and the spacer plate is connected between the magnetic component and the support beam.

**In** one of embodiments, a side surface of the spacer plate facing the magnetic component is provided with a mounting groove extending along the preset direction, the optical fiber arranged close to the magnetic component is inserted into the mounting groove, and a groove opening of the mounting groove is higher than a surface of the optical fiber.

**In** one of embodiments, the optical fiber sensor further includes a mounting body, and two ends of the support beam are respectively connected to the mounting body.

**In** one of embodiments, a mounting cavity is provided inside the mounting body, and the magnetic component, the optical fiber and the support beam are all received in the mounting cavity, and the two ends of the support beam are respectively fixedly connected to a cavity wall of the mounting cavity.

**In** one of embodiments, the magnetic component is fixedly connected to the optical fiber through a bonding structure.

A second objective of the present application is to provide a magnetic field intensity measurement device, comprising a light source, a fiber grating demodulation instrument, and the optical fiber sensor described above, and the light source and the fiber grating demodulation instrument are respectively connected to the optical fiber.

### BENEFICIAL EFFECT

The beneficial effects of the optical fiber sensor and magnetic field intensity measurement device of the present application compared with the existing technology are: compared with the existing technologies, the optical fiber sensor and the magnetic field intensity measurement device adopt the combination of the magnetic component and the optical fiber, and the magnetic component is connected to position of the Bragg grating on the optical fiber. Thus, when the optical fiber sensor is placed in the magnetic field, the magnetic component can move under the action of magnetic force to drive the optical fiber and the Bragg grating to bend and deform. Furthermore, the Bragg grating is affected by the stress change, and the wavelength of the reflected light wave of the light wave changes accordingly. By analyzing the change in the wavelength of the reflected light wave through the fiber Bragg grating demodulation instrument, the magnetic field intensity can be calculated. The optical fiber is an electrical insulator, and the Bragg grating is made of electrical insulating materials, so that no current passes through the optical fiber, and the optical fiber can be electrically isolated. The optical fiber and the Bragg grating will not be affected by electromagnetic interference or radio frequency interference, which is conducive to improving the sensing or measurement accuracy of the optical fiber sensor.

Furthermore, the structure of the optical fiber sensor is simple, the magnetic component is only required to be connected at the position where a Bragg grating is formed on the optical fiber. Through the movement of the magnetic component, stress changes are generated in the Bragg grating; the magnetic field intensity can be analyzed by collecting the wavelength of the changed reflected light waves. There is no need to use current-carrying conductors, nor is there a need to add current generation equipment to provide current, which is more conducive to reducing production costs.

### BRIEF DESCRIPTION OF THE DRAWINGS

In order to explain the embodiments of the present application more clearly, a brief introduction regarding the accompanying drawings that need to be used for describing the embodiments of the present application or the prior art is given below; it is obvious that the accompanying drawings described as follows are only some embodiments of the present application, for those skilled in the art, other drawings can also be obtained according to the current drawings on the premise of paying no creative labor.
FIG. 1 is a first structural schematic diagram of an optical fiber sensor provided by an embodiment of the present application;
FIG. 2 is an usage state schematic diagram of an optical fiber sensor bent and deformed in a magnetic field provided by an embodiment of the present application;
FIG. 3 is a schematic diagram of an internal structure of an optical fiber in an optical fiber sensor provided by an embodiment of the present application;
FIG. 4 is a second structural schematic diagram of an optical fiber sensor provided by an embodiment of the present application;
FIG. 5 is a third structural schematic diagram of an optical fiber sensor provided by an embodiment of the present application;
FIG. 6 is a fourth structural schematic diagram of an optical fiber sensor provided by an embodiment of the present application;
FIG. 7 is a top view of FIG. 6;
FIG. 8 is a structural schematic diagram of the connection between the spacer plate and the support beam in FIG. 6; and
FIG. 9 is an usage state schematic diagram of an optical fiber sensor bent and deformed in the magnetic field as shown in FIG. 6.

The reference numerals are listed as following:
1-magnetic component; 2-optical fiber; 21-Bragg grating; 22-first optical fiber; 23-second optical fiber; 3-spacer plate; 31-mounting groove; 4-support beam 5-mounting body; 51-mounting cavity; 6-magnet; 7-light beam; and 8-reflected light wave.

### DESCRIPTION OF THE EMBODIMENTS

Herein, embodiments of the present application are described in detail, and examples of the embodiment are illustrated in the accompanying figures; wherein, an always unchanged reference number or similar reference numbers represent(s) identical or similar components or components having identical or similar functionalities. The embodiment described below with reference to the accompanying figures is illustrative and intended to illustrate the present application, but should not be considered as any limitation to the present application.

In the description of the present application, it needs to be understood that, directions or location relationships indicated by terms such as "length", "width", "up", "down", "front", "rear" , "left" , "right" , "vertical" , "horizontal" , "top" , "bottom" , "inside" , "outside" , and so on are the directions or location relationships shown in the accompanying figures, which are only intended to describe the present application conveniently and simplify the description, but not to indicate or imply that an indicated device or component must have specific locations or be constructed and manipulated according to specific locations; therefore, these terms shouldn' t be considered as any limitation to the present application.

**In** addition, terms "the first" and "the second" are only used in describe purposes, and should not be considered as indicating or implying any relative importance, or implicitly indicating the number of indicated technical features. As such, technical feature(s) restricted by "the first" or "the second" can explicitly or implicitly comprise one or more such technical feature(s). **In** the description of the present application, "a plurality of" means two or more, unless there is additional explicit and specific limitation.

**In** the present application, unless there is additional explicit stipulation and limitation, terms such as "mount" , "connect with each other" , "connect" , "fix" , and so on should be generalizedly interpreted, for example, "connect" can be interpreted as being fixedly connected, detachably connected, or connected integrally; "connect" can also be interpreted as being mechanically connected or electrically connected; "connect" can be further interpreted as being directly connected or indirectly connected through intermediary, or being internal communication between two components or an interaction relationship between the two components. For the one of ordinary skill in the art, the specific meanings of the aforementioned terms in the present application can be interpreted according to specific conditions.

**In** order to make the purpose, the technical solution and the advantages of the present application be clearer and more understandable, herein, the present application is further described in detail below with reference to accompanying figures and embodiments.

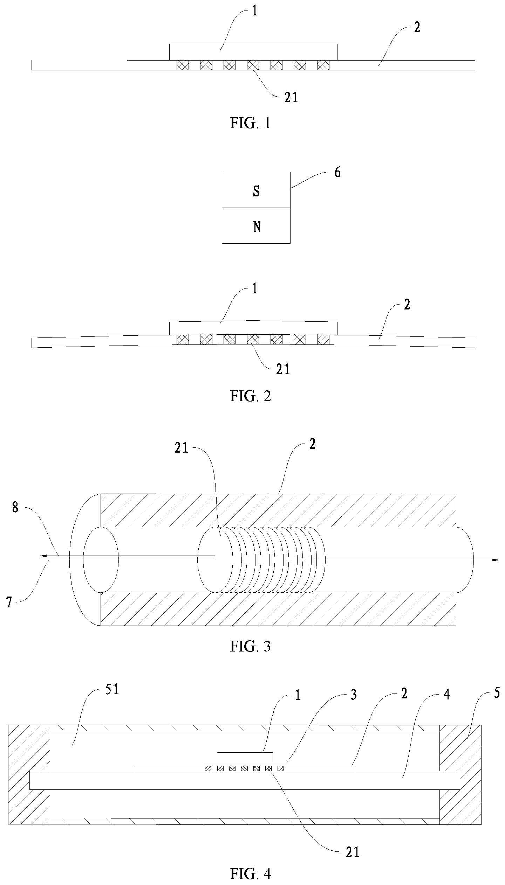

As shown in FIGS. 1 to 3, an embodiment of the present application provides an optical fiber sensor. The optical fiber sensor includes an optical fiber 2 and a magnetic component 1. At least one optical fiber 2 is provided, and the optical fiber 2 is extended and arranged along the preset direction, a preset position is provided on the extension length of the optical fiber 2, a Bragg grating 21 is formed on the preset position. The magnetic component 1 is connected to the preset position of the optical fiber 2, the magnetic component 1 is capable of positional offset under an action of a magnetic force to cause the Bragg grating 21 at the preset position to undergo bending and deformation perpendicular to the preset direction.

Specifically, the optical fiber 2 is the abbreviation of optical fiber, which is a kind of fiber made of glass or plastic and can be used as a light conduction tool. The transmission principle is total internal reflection of light. The diameter of optical fiber 2 can be less than or equal to 125 µm. The optical fiber 2 is an electrical insulator, so that no current passes through the optical fiber 2, and the optical fiber 2 can be electrically isolated, and the optical fiber 2 is not subject to electromagnetic interference or radio frequency interference.

The optical fiber 2 extends along the preset direction to form a strip or linear structure. The optical fiber 2 has a certain degree of elasticity or flexibility. When the optical fiber 2 is subjected to an external force approximately perpendicular to the length direction (the preset direction) of the optical fiber 2, the optical fiber 2 can bend and deform in the direction perpendicular to the preset direction. A Bragg grating 21 is formed in the middle of the extension length of the optical fiber 2. The Bragg grating 21 is formed at a preset position on the optical fiber 2, and the preset position is located in the middle area of the extension length of the optical fiber 2.

The Bragg grating 21 is a kind of fiber grating with uniform grating pitch, the reflection wavelength of which the is very small, and the distance between the reflection points of Bragg grating 21 is always equal. This kind of grating includes countless reflection points that can reflect specific wavelengths. By precisely matching the distances of the two reflection points, the light wave signal that meets the Bragg condition is reflected by the grating, while other wavelength signals are basically not reflected.

The Bragg Grating 21 is formed on the optical fiber 2 to manufacture the fiber Bragg grating. The fiber Bragg grating is abbreviated as FBG, and its full name is Fiber Bragg Grating, that is, the fiber Bragg grating, which is a grating with periodic spatial phase distribution formed in the fiber core. The essence of its function is to form a narrowband (transmission or reflection) filter or mirror within the fiber core. **In** this embodiment, the Bragg gratings 21 of different wavelengths or periods can be serially connected in the same optical fiber 2.

As shown in FIG. 3, the fiber Bragg grating exposes a small section of the light-sensitive fiber 2 to a light wave with a periodic distribution of light intensity through holographic interference or phase masking. Thus, the optical refractive index of the optical fiber 2 will permanently change according to the intensity of the light wave that the optical fiber 2 is illuminated. The periodic change in the refractive index of light caused by this method is called a fiber Bragg grating.

As shown in FIG. 3, when a broad-spectrum light beam 7 is propagated onto the fiber Bragg grating, each small section of the optical fiber 2 with a changed refractive index will only reflect a specific wavelength of light wave, which is called the Bragg wavelength. This characteristic causes the fiber Bragg grating to only reflect a specific wavelength of light wave, while light waves of other wavelengths will be propagated.

When the Bragg grating 21 is affected by stress or temperature changes, the grating pitch will change, and the wavelength of the reflected light wave will also change accordingly, and different wavelengths will be reflected. This wavelength can be collected and analyzed by the detection component (that is, the fiber Bragg grating demodulation instrument mentioned below).

The magnetic component 1 is magnetic and can be attracted or repelled by an external magnetic field, and generates motion under the action of magnetic force. The magnetic component 1 may include structural components made of metal materials such as iron, nickel, and cobalt, or alloy structural components made of the above-mentioned metal materials. When the magnetic component 1 is made of nickel material, the corrosion resistance of the magnetic component 1 can be stronger.

The magnetic component 1 is fixedly connected at the preset position of the optical fiber 2, that is, at the position where the Bragg grating 21 is arranged. The magnetic component 1 and the optical fiber 2 can be connected as a whole through a bonding structure, and the bonding structure can use an adhesive.

In the embodiment, when the optical fiber sensor is in use, the optical fiber 2 is respectively connected to the light source and the detection component used to detect the wavelength of the reflected light wave 8. The light source can generate a narrowband light beam 7, and the detection component can adopt a fiber grating demodulation instrument. The fiber grating demodulation instrument can measure the wavelength of the independent reflected light wave. The variation value of the wavelength of the reflected light wave 8 obtained by the reflection of the Bragg grating 21 is analyzed through the fiber Bragg grating demodulation instrument, so as to obtain the magnetic field intensity accordingly.

During the detection, the optical fiber sensor is placed in the magnetic field. The optical fibers 2 on both sides of the Bragg grating 21 have relatively fixed points respectively in the magnetic field to prevent the overall movement of the optical fibers 2 after being subjected to force. The magnetic field can be generated by magnetic generation devices such as magnets and electromagnets. As shown in FIG. 2, the magnetic field is generated by a magnet 6, which is located on the side of the optical fiber 2 and is set relative to the magnetic component 1, so that the magnetic field lines pass approximately perpendicularly through the preset positions of the magnetic component 1 and the optical fiber 2, that is, the magnetic field lines are caused to pass through the preset positions of the magnetic component 1 and the optical fiber 2 in a direction roughly perpendicular to the preset direction. The magnetic component 1 will move and generate displacement under the action of the magnetic field, and the magnetic component 1 will move in a direction roughly perpendicular to the preset direction, so as to cause the magnetic component 1 to drive the optical fiber 2 and the Bragg grating 21 on the optical fiber 2 to bend. After the Bragg grating 21 is bent, it is subjected to a force, that is, the Bragg grating 21 is affected by the stress change, and the wavelength of the reflected light wave 8 changes. The fiber Bragg grating demodulation instrument collects the wavelength of the changed emitted light wave, and analyzes the change in the wavelength of the emitted light wave before and after the bending and deformation of the Bragg grating 21, and the magnetic field intensity then can be analyzed. The specific analysis process of the magnetic field intensity is the working principle of the existing fiber Bragg grating demodulation instrument, which will not be repeated here.

In the embodiment, the optical fiber sensor adopt the combination of the magnetic component 1 and the optical fiber 2, and the magnetic component 1 is connected to position of the Bragg grating 21 on the optical fiber 2. Thus, when the optical fiber sensor is placed in the magnetic field, the magnetic component 1 can move under the action of magnetic force to drive the optical fiber 2 and the Bragg grating 21 to bend and deform. Furthermore, the Bragg grating 21 is affected by the stress change, and the wavelength of the reflected light wave of the light wave changes accordingly. By analyzing the change in the wavelength of the reflected light wave through the fiber Bragg grating demodulation instrument, the magnetic field intensity can be calculated. The optical fiber 2 is an electrical insulator, and the Bragg grating 21 is made of electrical insulating materials, so that no current passes through the optical fiber 2, and the optical fiber 2 can be electrically isolated. The optical fiber 2 and the Bragg grating 21 will not be affected by electromagnetic interference or radio frequency interference, which is conducive to improving the sensing or measurement accuracy of the optical fiber sensor.

Furthermore, the structure of the optical fiber sensor is simple, the magnetic component 1 is only required to be connected at the position where a Bragg grating 21 is formed on the optical fiber 2. Through the movement of the magnetic component 1, stress changes are generated in the Bragg grating 21; the magnetic field intensity can be analyzed by collecting the wavelength of the changed reflected light waves. There is no need to use current-carrying conductors, nor is there a need to add current generation equipment to provide current, which is more conducive to reducing production costs.

In one embodiment, the optical fiber 2 can be made of a silicon dioxide material. The silicon dioxide has the characteristic of high-temperature resistance. Moreover, the silicon dioxide is a passive and inert solid substance, so it is less affected by temperature changes. This enables the optical fiber sensor to be applied in a temperature environment at least above 100°C. Compared with the existing technology, the applicable environmental temperature range is wider.

In one embodiment, as shown in FGS. 4 to 6, the optical fiber sensor further includes a support beam 4 capable of bending and deformation. The optical fiber 2 and the magnetic component 1 are both connected to the support beam 4, and the optical fiber 2 is arranged in the same direction as the support beam 4.

Specifically, the support beam 4 extends along the preset direction to form a strip. That is, the central axis of the support beam 4 is along the preset direction, and the extension direction of the support beam 4 is the same as that of the optical fiber 2. The cross-section of the support beam 4 is circular, elliptical or polygonal, etc. As shown in FIG. 3, the cross-section of the support beam 4 is rectangular. The outer surface of the support beam 4 is provided with a mounting plane. The optical fiber 2 is mounted on the mounting plane, and the optical fiber 2 can be fixedly connected to the mounting plane of the support beam 4 through the adhesive.

The support beam 4 is a non-magnetic structural component. The support beam 4 is not magnetic and is not disturbed by the magnetic field force. The mass of the support beam 4 should be as light as possible. Therefore, the support beam 4 is made of lightweight materials, such as aluminium. The support beam 4 is elastic. When the support beam 4 is subjected to a force approximately perpendicular to the preset direction, the support beam 4 can undergo a bending and deformation approximately perpendicular to the preset direction.

The optical fiber 2 can be mounted on either side of the support beam 4. The magnetic component 1 and the optical fiber 2 can be connected to the same side of the support beam 4, or the magnetic component 1 and the optical fiber 2 can be connected to different sides of the support beam 4. When the magnetic component 1 and the optical fiber 2 are connected to the same side of the support beam 4, the optical fiber 2 is located between the magnetic component 1 and the support beam 4. The optical fiber 2, the magnetic component 1 and the support beam 4 can be bonded together through the adhesive to form an integral structure.

In the embodiment, the support beam 4 mainly plays a supporting role for the optical fiber 2. The Bragg grating 21 on the optical fiber 2 is located in the middle area of the support beam 4. When the magnetic field generates a magnetic force on the magnetic component 1, causing the magnetic component 1 to move, the magnetic component 1 drives the support beam 4 to bend. Since the optical fiber 2 is connected to the support beam 4, the optical fiber 2 and the support beam 4 undergo bending and deformation simultaneously, which in turn causes the Bragg grating 21 on the optical fiber 2 to be affected by the stress change, and the wavelength of the reflected light wave 8 changes accordingly. The magnetic field intensity is calculated by analyzing the change in the wavelength of the reflected light wave through the fiber grating demodulation instrument.

Furthermore, the sensitivity of the optical fiber sensor in the embodiment can be adjusted by regulating the thickness and width of the support beam 4 in the direction perpendicular to the preset direction. The smaller the thickness of the support beam 4, the higher the sensitivity of the sensor; the smaller the width of the support beam 4, the higher the sensitivity of the sensor. In addition, the magnetic component 1 can adopt a sheet-like structure. The larger the surface area of the magnetic component 1, the higher the sensitivity of the sensor. Especially, the wider the width direction of the magnetic component 1 perpendicular to the preset direction, the higher the sensitivity of the sensor. The adjustable sensitivity allows users to customize the optical fiber sensor. The sensitivity of the sensor to magnetic field intensity is determined by the size and physical parameters of constituent components of the sensor. This optical fiber sensor can also reduce its sensitivity by thickening, shortening or widening the support beam 4. These factors will serve as the basis for initializing the parameters of the optical fiber sensor within different measurement ranges.

For the directionality of the optical fiber sensor in the embodiment, the directionality of the sensor can be adjusted by regulating the ratio of the surface area to the thickness of the magnetic component 1. The higher the ratio of the surface area to the thickness of the magnetic component 1, the higher the directionality. Along with the direction of the support beam 4, the optical fiber sensor is designed to have the highest directionality upward (towards the magnet 6).

For the optical fiber sensor in the embodiment, the purpose of reducing mechanical vibration interference can be achieved by maximizing the thickness of the support beam 4, minimizing the weight of the support beam 4 or minimizing the weight of the magnetic component 1.

In one embodiment, as shown in FIG. 4, the support beam 4 is located on the side of the optical fiber 2 away from the magnetic component 1, that is, the optical fiber 2 is located between the magnetic component 1 and the support beam 4, and the magnetic component 1, the optical fiber 2 and the support beam 4 are bonded together as a whole by an adhesive.

In the embodiment, the two ends of the support beam 4 can be set relatively fixedly in the magnetic field. Specifically, the two ends of the support beam 4 can be fixedly connected to other fixed structures in the magnetic field. When the upper part of the magnetic component 1 (i.e., the side of the magnetic component 1 that is away from the support beam 4) is attracted by the magnetic field, the support beam 4 and the optical fiber 2 bend outward towards the upper part of the magnetic component 1. Then, the upper side of the support beam 4 (the side of the support beam 4 facing the magnetic component 1) bends and is subjected to tensile force, while the lower side of the support beam 4 that is away from the upper side is subjected to compressive force. That is, the upper side of the support beam 4 is subjected to positive strain force, and the lower side is subjected to negative strain force. The optical fiber 2 mounted on the upper side of the support beam 4 and the Bragg grating 21 on the optical fiber 2 are subjected to positive strain force, and the wavelength of the reflected light wave changes accordingly. The greater the magnetic field, the greater the change in the wavelength of the reflected light wave, and the greater the amplitude of the wavelength shift.

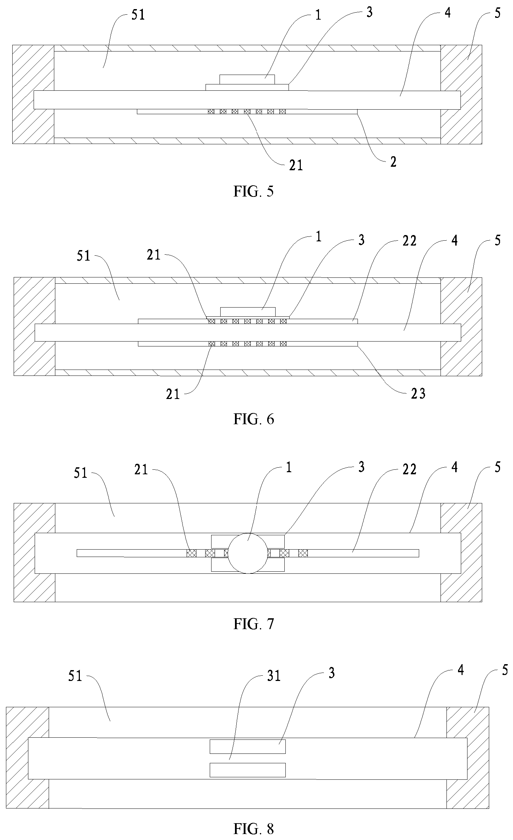

In one embodiment, as shown in FIG. 5, the support beam 4 is located on the side of the optical fiber 2 facing the magnetic component 1, and is located between the optical fiber 2 and the magnetic component 1. The magnetic component 1, the optical fiber 2 and the support beam 4 are bonded together as a whole by an adhesive.

In the embodiment, the two ends of the support beam 4 can be set relatively fixedly in the magnetic field. Specifically, the two ends of the support beam 4 can be fixedly connected to other fixed structures in the magnetic field. The support beam 4 is connected between the optical fiber 2 and the magnetic component 1. When the upper part of the magnetic component 1 (i.e., the side of the magnetic component 1 away from the support beam 4) is attracted by the magnetic field, the support beam 4 and the optical fiber 2 bend outward towards the upper part of the magnetic component 1. Then, the upper side of the support beam 4 (the side of the support beam 4 facing the magnetic component 1) bends and is subjected to tensile force. The lower side of the support beam 4 that is opposite to the upper side is subjected to pressure. That is, the upper side of the support beam 4 is subjected to positive strain force, and the lower side is subjected to negative strain force. The optical fiber 2 is connected to the lower side of the support beam 4 (the side of the support beam 4 away from the magnetic component 1), and the optical fiber 2 mounted on the lower side of the support beam 4 and the Bragg grating 21 on the optical fiber 2 are subjected to negative strain force. The wavelength of the reflected light wave changes accordingly. The greater the magnetic field, the greater the change in the wavelength of the reflected light wave, and the greater the amplitude of the wavelength shift.

In one embodiment, as shown in FIGS. 6 and 7, two optical fibers 2 are provided, and the two Bragg gratings 21 on the two optical fibers 2 are respectively arranged relative to each other; the magnetic component 1 is connected to the side of any of the optical fibers 2 that is away from the support beam 4. Two optical fibers 2 are respectively used to connect with the fiber Bragg grating demodulation instrument. By comprehensively analyzing the wavelength changes of the reflected light waves passing through the two optical fibers 2, the wavelengths of the reflected light waves passing through the two optical fibers 2 can be superimposed and analyzed, so as to enable more accurate calculation of the magnetic field intensity and to improve the measurement accuracy.

For the convenience of description, in the embodiment, the two opposite side surfaces of the support beam 4 are defined as the first side surface and the second side surface respectively, and the two optical fibers 2 are defined as the first optical fiber 22 and the second optical fiber 23 respectively.

Specifically, the two optical fibers 2 are respectively connected in parallel to the opposite sides of the support beam 4, meaning that the first optical fiber 22 is connected to the first side surface of the support beam 4, and the second optical fiber 23 is connected to the second side surface of the support beam 4. The magnetic component 1 is connected to the first side surface of the support beam 4, and the first optical fiber 22 is located between the magnetic component 1 and the first side surface of the support beam 4. The magnetic component 1, the first optical fiber 22, the second optical fiber 23 and the support beam 4 can be bonded and fixed into an integrated structure through the adhesive.

The two ends of the support beam 4 can be fixedly arranged relative to each other in the magnetic field. Specifically, the two ends of the support beam 4 can be fixedly connected to other fixed structures in the magnetic field. The first optical fiber 22, the second optical fiber 23 and the magnetic component 1 are located in the middle area of the extension length of the support beam 4.

In the embodiment, when the upper part of the magnetic component 1 (i.e., the side of the magnetic component 1 away from the support beam 4) is attracted by the magnetic field, the support beam 4, the first optical fiber 22 and the second optical fiber 23 bend outward towards the upper part of the magnetic component 1, then the upper side of the support beam 4 (the side of the support beam 4 facing the magnetic component 1) is bent and subjected to tensile force. The lower side of the support beam 4 away from the upper side (the side of the support beam 4 away from the magnetic component 1) is subjected to compressive force. That is, the upper side of the support beam 4 is subjected to positive strain force, and the lower side of the support beam 4 is subjected to negative strain force. The directions of the strain forces on the upper and lower sides of the support beam 4 are opposite.

Therefore, the first optical fiber 22 located on the upper side of the support beam 4 and the Bragg grating 21 on the first optical fiber 22 are subjected to the action of the positive strain force, and the wavelength of the reflected light wave wave changes towards a positive offset. The second optical fiber 23 mounted on the lower side of the support beam 4 and the Bragg grating 21 on the second optical fiber 23 are subjected to the negative strain force, and the wavelength of the reflected light wave changes towards a negative offset. The positive offset direction and negative offset direction of the wavelength of the reflected light wave are opposite, and the offset values are the same. Therefore, in the embodiment, using two optical fibers 2 can make the change value of the wavelength of the reflected light wave twice that of one optical fiber 2. The value transmitted by the sensor to the fiber grating demodulation instrument in the embodiment is expanded to twice that of one optical fiber 2, and the signal change amplitude is increased to twice. Therefore, it enables the fiber Bragg grating sensor to calculate the magnetic field intensity more accurately based on the data of the wavelength change of the reflected light wave, which is conducive to improving the measurement accuracy. The greater the magnetic field, the greater the change in the wavelength of the reflected light wave, and the greater the amplitude of the wavelength shift.

In addition, the optical fiber sensors that are symmetrically arranged on both sides of the support beam 4 with the two optical fibers 2 apart as mentioned above can counteract the influence of temperature on the wavelengths of the two reflected light waves, which is conducive to improving the accuracy of the collected and measured data.

Furthermore, the first optical fiber 22 and the second optical fiber 23 are respectively arranged on the upper and lower sides of the support beam 4. The above arrangement enables the influence of temperature on the first optical fiber 22 and the second optical fiber 23 to cancel each other out. The above structure can form temperature compensation, making the overall structure have good temperature difference stability and be able to withstand higher temperature environments.

In one embodiment, as shown in FIGS. 4 to 8, the optical fiber sensor further comprises a spacer plate 3, which is used to separate the magnetic component 1 from the optical fiber 2 arranged close to the magnetic component 1; the optical fiber 2 arranged close to the magnetic component 1 is the first optical fiber 22; the spacer plate 3 is connected between the magnetic component 1 and the support beam 4.

Specifically, the magnetic component 1 is in a sheet shape. As shown in FIGS. 6 to 8, the outer contour shape of the cross-section of the magnetic component 1 is circular. The spacer plate 3 is in a sheet shape, a side surface of the spacer plate 3 is connected to a side surface (a lower side surface) of the optical fiber 2 facing the magnetic component 1 (in the embodiment, the optical fiber 2 hereinafter refers to the first optical fiber 22), and the other side surface of the spacer plate 3 is connected to a side surface (an upper side surface) of the support beam 4 facing the optical fiber 2. The spacer plate 3 is located between the magnetic component 1 and the support beam 4. The thickness of the spacer plate 3 is greater than the diameter of the optical fiber 2, so that the spacer plate 3 can avoid the optical fiber 2 and prevent it from coming into direct contact with the magnetic component 1.

In the embodiment, by adding the spacer plate 3, the spacer plate 3 is connected between the magnetic component 1 and the support beam 4. The spacer plate 3 is arranged to avoid the optical fiber 2, so that the optical fiber 2 does not come into direct contact with the magnetic component 1 and plays a protective role for the optical fiber 2.

In one embodiment, as shown in FIGS. 7 and 8, a mounting groove 31 extending in a preset direction is provided on a side surface of the spacer plate 3 facing the magnetic component 1. The optical fiber 2 arranged close to the magnetic component 1 is inserted into the mounting groove 31, and the groove opening of the mounting groove 31 is higher than the surface of the optical fiber 2.

It should be noted that in the embodiment, the following optical fibers 2 all refer to the first optical fiber 22.

Specifically, a side where the spacer plate 3 is connected to the magnetic component 1 is provided with the mounting groove 31. The mounting groove 31 is used to receive the optical fiber 2. In order to prevent the optical fiber 2 placed in the mounting groove 31 from coming into contact with the magnetic component 1 on the surface of the spacer plate 3, the depth of the mounting groove 31 is greater than the diameter of the optical fiber 2, so that when the optical fiber 2 is inserted into the mounting groove 31, the groove opening of the mounting groove 31 is higher than the surface of the optical fiber 2. The surface of the optical fiber 2 and the lower surface of the magnetic component 1 can form a gap space, so as to prevent the optical fiber 2 from coming into direct contact with the magnetic component 1 and protect the optical fiber 2.

In the embodiment, as shown in FIGS. 7 and 8, the mounting groove 31 in the spacer plate 3 can be a through groove, and the bottom of the mounting groove 31 can extend to the surface of the support beam 4. Therefore, the spacer plate 3 is divided into two parts, and the two parts of the spacer plate 3 are respectively located on both sides of the optical fiber 2. The structural form of the spacer plate 3 is not limited to the forms listed in this embodiment. Any form of spacer plate 3 that can separate the optical fiber 2 from the magnetic component 1 should be within the protection scope of the present application.

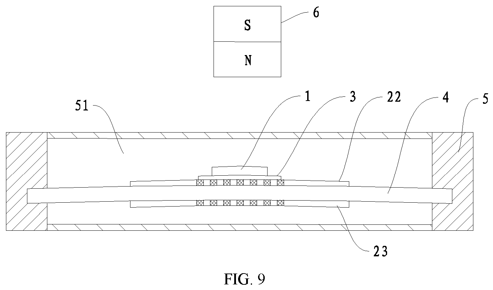

In one embodiment, as shown in FIGS. 4 to 9, the optical fiber sensor further includes a mounting body 5, and the two ends of the support beam 4 are respectively connected to the mounting body 5.

In the embodiment, the mounting body 5 is a holding structure for fixing the support beam 4. The support beam 4 can be fixedly or detachably connected to the mounting body 5. The two ends of the support beam 4 are connected to the mounting body 5, so that the two ends of the support beam 4 can be relatively fixed in the magnetic field, so that it can bend and deform in the middle when subjected to the magnetic field force.

In one embodiment, as shown in FIGS. 4 to 9, a mounting cavity 51 is provided inside the mounting body 5. The magnetic component 1, the optical fiber 2 and the support beam 4 are all received in the mounting cavity 51, and the two ends of the support beam 4 are respectively fixedly connected to the cavity wall of the mounting cavity 51.

Specifically, the mounting body 5 can adopt a shell or a frame structure. The exterior of the mounting body 5 can be cylindrical or cubic. The mounting body 5 can be made of plastic material to reduce electromagnetic and radio frequency interference. The mounting cavity 51 provided inside the mounting body 5 allows the overall structure composed of the magnetic component 1, the optical fiber 2, the support beam 4 and the spacer plate 3 to be received within the mounting cavity 51. The two ends of the support beam 4 extend to the cavity wall of the mounting cavity 51 and are fixedly connected to the cavity wall of the mounting cavity 51.

In the embodiment, by receiving the overall structure of the magnetic component 1, the optical fiber 2 and the support beam 4 within the mounting cavity 51 inside the mounting body 5, the overall structure of the magnetic component 1, the optical fiber 2 and the support beam 4 can be protected. Additionally, the design of the above-mentioned mounting body 5 makes the overall movement and use of the optical fiber sensor more convenient.

In conclusion, the optical fiber sensor can be reused, transmitted over long distances, and has the advantages of electrical isolation, high temperature and pressure resistance, and good long-term stability. Compared with traditional electronic sensors, the most notable feature of the optical fiber sensor is that it is based on a fiber Bragg grating sensor, which overcomes the common electromagnetic interference and radio frequency interference problems that frequently occur in on-site scenarios.

The second objective of the present application is to provide a magnetic field intensity measurement device. The magnetic field intensity measurement device includes a light source, a fiber grating demodulation instrument, and the optical fiber sensor in the above embodiments. The light source and the fiber grating demodulation instrument are respectively connected to the optical fiber 2.

Specifically, the light source can irradiate to produce a light beam 7 and generate light waves. The light source is connected to the optical fiber 2 for inputting light waves or light wave signals into the optical fiber 2. The fiber Bragg grating demodulation instrument is used to receive the wavelength signal of the light wave 8 reflected by the Bragg grating 21, and obtain the magnetic field intensity through analysis and calculation.

In the embodiment, the optical fiber sensor in the magnetic field intensity measurement device adopt the combination of the magnetic component 1 and the optical fiber 2, and the magnetic component 1 is connected to position of the Bragg grating 21 on the optical fiber 2. Thus, when the optical fiber sensor is placed in the magnetic field, the magnetic component 1 can move under the action of magnetic force to drive the optical fiber 2 and the Bragg grating 21 to bend and deform. Furthermore, the Bragg grating 21 is affected by the stress change, and the wavelength of the reflected light wave of the light wave changes accordingly. By analyzing the change in the wavelength of the reflected light wave through the fiber Bragg grating demodulation instrument, the magnetic field intensity can be calculated. The optical fiber 2 is an electrical insulator, and the Bragg grating 21 is made of electrical insulating materials, so that no current passes through the optical fiber 2, and the optical fiber 2 can be electrically isolated. The optical fiber 2 and the Bragg grating 21 will not be affected by electromagnetic interference or radio frequency interference, which is conducive to improving the sensing or measurement accuracy of the optical fiber sensor.

The magnetic field intensity measurement device can develop an online system by using wireless transmission technology. By mounting the optical fiber sensor on mobile vehicles, unmanned aerial vehicles and other devices, it can calculate the entire magnetic field intensity. **In** the short term, the optical fiber sensor can be tested and implemented in various experimental and engineering scenarios that are very important but have severe electromagnetic and radio frequency interference. All organizations that need to measure magnetic fields in high electromagnetic interference environments and high ambient temperatures, as well as those where the sensor is widely distributed in large-area synchronization, are potential target licenters. **In** the long run, the optical fiber sensor will be able to be mass-produced and used by professionals.

The above are merely the preferred embodiments of the present application, only specifically describing the technical principles of the present application. These descriptions are only for explaining the principles of the present application and cannot be interpreted in any way as a limitation on the scope of protection of the present application. Based on this interpretation, any modifications, equivalent replacements and improvements made within the spirit and principles of the present application, as well as other specific implementation methods that those skilled in the art can associate with the present application without the need for creative labor, should all be included within the protection scope of the present application.

## Claims

1. An optical fiber sensor, comprising:
at least one optical fiber, extended and arranged along a preset direction, wherein a preset position is arranged on an extension length of the optical fiber, and a Bragg grating is formed at the preset position; and
a magnetic component, connected to the preset position of the optical fiber, wherein the magnetic component is capable of positional offset under an action of a magnetic force to cause the Bragg grating at the preset position to undergo bending and deformation perpendicular to the preset direction.

2. The optical fiber sensor according to claim 1, wherein the optical fiber sensor further comprises a support beam capable of bending and deformation, the optical fiber and the magnetic component are both connected to the support beam, and the optical fiber is extended and arranged in a same direction as the support beam.

3. The optical fiber sensor according to claim 2, wherein the support beam is located on a side of the optical fiber away from the magnetic component; or
the support beam is located on a side of the optical fiber facing the magnetic component and is located between the optical fiber and the magnetic component.

4. The optical fiber sensor according to claim 2, wherein two optical fibers are provided, the two optical fibers are respectively connected in parallel to opposite sides of the support beam, and two Bragg gratings on the two optical fibers are respectively arranged correspondingly; and the magnetic component is connected to a side of any of the two optical fibers away from the support beam.

5. The optical fiber sensor according to claim 4, wherein the optical fiber sensor further comprises a spacer plate configured to separate the magnetic component from the optical fiber arranged close to the magnetic component; and the spacer plate is connected between the magnetic component and the support beam.

6. The optical fiber sensor according to claim 5, wherein a side surface of the spacer plate facing the magnetic component is provided with a mounting groove extending along the preset direction, the optical fiber arranged close to the magnetic component is inserted into the mounting groove, and a groove opening of the mounting groove is higher than a surface of the optical fiber.

7. The optical fiber sensor according to any one of claims 2 to 6, wherein the optical fiber sensor further comprises a mounting body, and two ends of the support beam are respectively connected to the mounting body.

8. The optical fiber sensor according to claim 7, wherein a mounting cavity is provided inside the mounting body; the magnetic component, the optical fiber and the support beam are all received in the mounting cavity, and the two ends of the support beam are respectively fixedly connected to a cavity wall of the mounting cavity.

9. The optical fiber sensor according to any one of claims 1 to 6, wherein the magnetic component is fixedly connected to the optical fiber through a bonding structure.

10. A magnetic field intensity measurement device, comprising a light source, a fiber grating demodulation instrument, and the optical fiber sensor according to any one of claims 1 to 9, wherein the light source and the fiber grating demodulation instrument are respectively connected to the optical fiber.
